# EUROPEAN PATENT SPECIFICATION

(11) **EP 0 317 150 B1**
(45) Date of publication and mention of the grant of the patent: **02.03.1994**
(21) Application number: 88310472.1
(22) Date of filing: 08.11.1988
(51) Int. Cl.: H03K 3/282

(54) **Voltage controlled oscillator**
Spannungsgesteuerter Oszillator
Oscillateur commandé par une tension

(30) Priority: 19.11.1987 US 123024
(43) Date of publication of application: 24.05.1989
(73) Proprietor: International Business Machines Corporation, Armonk, N.Y. 10504 (US)
(72) Inventor: Chung, Paul Wingshing, San Jose, CA 95119 (US); Saber, Paik (NMN), San Jose, CA 95139 (US)
(74) Representative: Burt, Roger James, Dr.

(56) References cited:
- FR-A- 2 204 076
- US-A- 3 904 989
- WIRELESS WORLD vol. 78, no. 1436, February 1972, page 78 ;S. TESIC: "Stable voltage-to-frequency converter"
- IBM TECHNICAL DISCLOSURE BULLETIN. vol. 14, no. 2, July 1971, NEW YORK US pages 578 - 579; H.W. JOHNSON: "Stable symetrical gateable VCO"
- A.B. Williams, "Designer's Handbook of Integrated Circuits", Mc Graw-Hill Book Company, 1984, pages 2-21 to 2-23.

## Description

The present invention relates to a voltage controlled oscillator.

A voltage controlled oscillator as defined in the preamble of claim 1 is known from A. B. Williams, "Designer's Handbook of Integrated Circuits", McGraw-Hill Book Company, 1984, pages 2-21 to 2-23. This known state of the art also comprises collector resistors configured as matched current links.

In disk storage systems, sampling by a disk controller of readback signals representing stored data information requires synchronisation of the controller's clock to data pulses communicated from the disk. In conventional disk storage subsystems, this synchronisation is achieved using a voltage controlled oscillator (VCO) to continuously adjust the frequency. To provide constantly accurate synchronisation, the frequency of the oscillator at a set voltage has to be stable over a wide temperature range. Furthermore, to improve the sampling capability of the controller, it is desirable to have a VCO that has a wide range of linear voltage vs. frequency relationship.

On the other hand, the present industrial trend of increasing storage device capacity through data banding and constant data density recording also requires an oscillator that has a wide linear range of frequency vs. voltage relationship. (See 'Constant-Density Recording Comes Alive With New Chips', Electronic Design, November 13, 1986, pp. 141-144).

However, both the frequency vs. voltage relationship and the temperature sensitivity of a semiconductor device are dictated by the characteristics of its constituents. Since the frequency vs. voltage relationship of semiconductor components follows the expotential and square laws, and since semiconductor components are sensitive to temperature changes, currently available semiconductor VCOs consequently can only operate within a narrow range of linear frequency vs. voltage relationship, and have a strong dependency on their operating temperatures.

The article titled 'Stable Voltage-to-Frequency Converter', Wireless World, Vol. 78, No 1436, Feb 1972, page 78 describes a hybrid circuit containing a combination of conventional and m.o.s. transistors in which the operating points of m.o.s.f.e.t.s are placed in the region of the positive temperature coefficient so as to improve temperature stability.

In current manufacturing processes of disk storage devices, the above mentioned desired capabilities of VCOs are attained by laser trimming a VCO so that the centre point of its linear frequency/voltage region coincides with the central operating frequency of the system. Laser trimming the VCOs, however, is a costly process.

UK Patent No 3,904,989 titled 'Voltage Controlled Emitter-Coupled Multivibrator with Temperature Compensation' describes a high-speed temperature-compensated integrated circuit voltage-controlled oscillator. Temperature compensation is achieved by establishing virtually identical temperature dependency in the current which charges a multivibrator timing capacitor and in the voltage swing which appears across the timing capacitor.

The invention seeks to provide a voltage controlled oscillator which has temperature stability.

In one aspect, the invention provides a voltage controlled oscillator comprising an emitter coupled multivibrator comprising two cross-coupled bipolar transistors for switching the multivibrator, the multivibrator being subject to frequency variations as a result of the bipolar transistors being subject to temperature fluctuations; current sources coupled between the emitters of the bipolar transistors and a corresponding power supply line; and a capacitor connected between the emitters of the bipolar transistors, characterised in that the current sources are FET current sources which are adjustable for providing frequency control and constantly drain the capacitor wherein the output current of the FET current sources decreases as the temperature rises thereby compensating for temperature fluctuations of the bipolar transistors; resistive means coupled between the collectors of to the bipolar transistors and a second power supply rail for regulating their current to provide a linear frequency versus voltage relationship; and a plurality of diodes coupled in series with the resistive means for regulating the current through the resistive means.

Viewed from another aspect the present invention provides a method for generating temperature-stable, voltage controllable oscillating signals, comprising the steps of: switching an emitter coupled multivibrator comprising a pair of bipolar transistors and a capacitor coupled between the emitters of the bipolar transistors, the multivibrator being subject to frequency variations as a result of the bipolar device being subject to temperature fluctuations; compensating temperature fluctuations of the bipolar transistors with adjustable FET current sources coupled between the emitters of the bipolar transistors and a corresponding power supply line by decreasing the output current of the FET current source as the temperature rises; regulating the current of the bipolar device to provide a linear frequency versus voltage relationship by coupling resistive means between the collectors of the bipolar transistors and a second power supply rail; and connecting the resistive means in series with a plurality of diodes thereby regulating the current through the resistive means.

Other aspects of the invention are defined in the claims appended hereto.

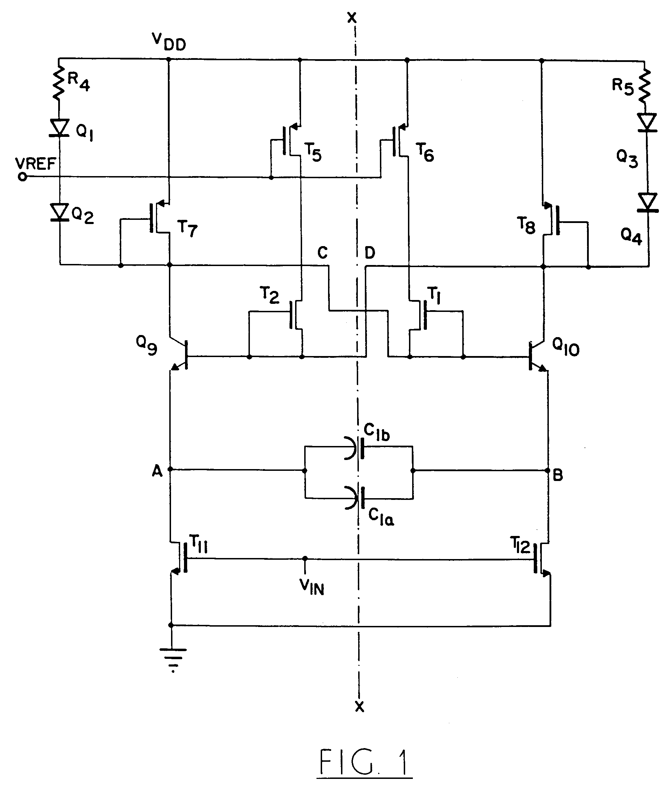

How the invention can be carried out will now be described by way of example, with reference to the accompanying drawing (Fig. 1) which is a schematic diagram of a voltage controlled oscillator embodying the invention.

Referring to the drawing, a voltage controlled oscillator (VCO) circuit comprises capacitors C_{1b} and C₁ₐ which are connected in parallel across nodes A and B with a combined capacitance of C. These two capacitors can be implemented as on chip Metal Oxide Semiconductor (MOS) capacitors and can also be replaced by one or more capacitors to provide the desired capacitance C across the nodes.

On each side of the capacitor pair C_{1b} and C₁ₐ is an n-channel Field Effect Transistor (FET), T₁₁ and T₁₂ respectively, biased into saturation by input voltage VIN to provide a current source constantly draining the capacitors. Also connected to one side of the capacitor pair C₁ₐ, C_{1b}, is the emitter of a bipolar transistor Q₉ and the other side of said pair is connected to a bipolar transistor Q₁₀, to provide a charging current to the capacitors.

Connected to the collector of transistor Q₉ is one or more networks each composed of a resistor, R₄, connected in series with one or more bipolar diodes, Q₁ and Q₂. Similarly, connected to the collector of transistor Q₁₀ is one or more serial combinations of resistor R₅ and one or more bipolar diodes, Q₃ and Q₄.

The operation of the circuit can be described by first assuming that bipolar transistor Q₉ is on and bipolar transistor Q₁₀ is off. Node C, to which is connected the collector of bipolar transistor Q₉, will be clamped at a voltage equal to a voltage drop across two bipolar diodes (Q₁ and Q₂) and a voltage drop I₄R₄ below V_{DD}, I₄ being the current flowing through the resistor R₄.

The current through bipolar transistor Q₉ is greater than the discharge current of FET T₁₁. Consequently, this current charges the capacitor pair, C₁ₐ and C_{1b}, and raises the voltage of node A. This charging current, however, is regulated by the resistor R₄. A low threshold FET T₁ is provided across node D and the base of transistor Q₁₀ to clamp the voltage swing of node D. Similarly, a low threshold FET T₂ is provided across node C and the base of transistor Q₉ to clamp the voltage swing of node C. Clamping the voltages by these low threshold FETs improves the switching speed of the voltage across C and D, which is the output of the VCO.

With the low threshold of FET T₂ connected to the base and collector of transistor Q₉, the voltage across the base and collector of Q₉ will be clamped at the same voltage as the voltage drop across FET T₂. Similarly, with the low threshold FET T₁ connected to the base and collector of transistor Q₁₀, the voltage across the base and collector of Q₁₀ will be clamped at the same voltage as the voltage drop across FET T₁. This voltage drop across FET T₂ can be calculated by the current equation of the FET in saturation condition.

Diodes Q₁ and Q₂ regulate the current through resistor R₄. Similarly, diodes Q₃ and Q₄ regulate the current through resistor R₅. Since the charging current provided by each of current sources Q₉ and Q₁₀ passes respectively through R₄ and R₅, it follows the Ohm's law. Thus, wide linear frequency range of the VCO is achieved by replacing the exponential and the square law dependency of the current vs voltage relationship with a Ohm's law dependency.

While the voltage at node A is rising towards the voltage at node D minus a base-emitter voltage drop V_{be} of transistor Q₉, the voltage at node B of the capacitor pair, being discharged by T₁₂, is falling towards ground. When the voltage at node B falls below a base-emitter voltage (V_{be}) drop below node C, Q₁₀ will turn on and Q₉ will turn off. Since the VCO circuit is symmetrical about line X-X, this toggling action repeats itself.

Loads T₅, T₆, T₇ and T₈ are used to established the operating voltage point of the oscillator.

When the operating temperature increases, the switching speed of the bipolar transistors, Q₉ and Q₁₀, will increase. However, the same increase in operating temperature will slow down FETs T₁₁ and T₁₂ which drain the current from the capacitors, thereby slowing down the switching speed. Thus, with any temperature changes, the change in speed due to the bipolar transistors Q₉ and Q₁₀ is offset by a corresponding change in rate of discharge by the FET current sources T₁₁ and T₁₂ in the opposite direction. Thus, the temperature sensitivity coefficients of the FET and BIPOLAR device complement each other.

Although the circuit is implemented with particular semiconductor device type, other devices having the same characteristics can be used. For example, p-channel FETs can be replaced by n-channel FETs in the circuits if corresponding changes on other parts of the circuits are made.

## Claims

1. A voltage controlled oscillator comprising:
an emitter coupled multivibrator comprising two cross-coupled bipolar transistors for switching the multivibrator, the multivibrator being subject to frequency variations as a result of the bipolar transistors being subject to temperature fluctuations;
current sources coupled between the emitters of the bipolar transistors and a corresponding power supply line; and
a capacitor connected between the emitters of the bipolar transistors,
characterised in that the current sources are FET current sources which are adjustable for providing frequency control and constantly drain the capacitor wherein the output current of the FET current sources decreases as the temperature rises thereby compensating for temperature fluctuations of the bipolar transistors;
resistive means coupled between the collectors of the bipolar transistors and a second power supply rail for regulating their current to provide a linear frequency versus voltage relationship; and
a plurality of diodes coupled in series with the resistive means for regulating the current through the resistive means.

2. A voltage controlled oscillator as claimed in claim 1 further comprising a plurality of FET loads for establishing the output voltage of the oscillator.

3. A voltage controlled oscillator as claimed in any of claims 1 or 2 further comprising limiting means for limiting the output voltage swing of the multivibrator for improving the switching speed thereof.

4. A voltage controlled oscillator as claimed in claim 3 wherein the limiting means is a low threshold FET.

5. A method for generating temperature-stable, voltage controllable oscillating signals, comprising the steps of:
switching an emitter coupled multivibrator comprising a pair of bipolar transistors and a capacitor coupled between the emitters of the bipolar transistors, the multivibrator being subject to frequency variations as a result of the bipolar device being subject to temperature fluctuations;
compensating temperature fluctuations of the bipolar transistors with adjustable FET current sources coupled between the emitters of the bipolar transistors and a corresponding power supply line by decreasing the output current of the FET current source as the temperature rises;
regulating the current of the bipolar device to provide a linear frequency versus voltage relationship by coupling resistive means between the collectors of the bipolar transistors and a second power supply rail; and
connecting the resistive means in series with a plurality of diodes thereby regulating the current through the resistive means.

## Patentansprüche

1. Ein spannungsgesteuerter Oszillator, der folgendes umfaßt:
einen emittergekoppelten Multivibrator, der zwei kreuzgekoppelte bipolare Transistoren zum Schalten des Multivibrators enthält, wobei der Multivibrator als Ergebnis dadurch, daß die bipolaren Transistoren Temperaturabweichungen unterliegen, Frequenzschwankungen ausgesetzt ist;
Stromquellen, die zwischen den Emittern der bipolaren Transistoren und einer dazugehörigen Stromversorgungsleitung gekoppelt sind; und
ein Kondensator, der zwischen den Emittern der bipolaren Transistoren angeschlossen ist,
dadurch charakterisiert, daß es sich bei den Stromquellen um FET-Stromquellen handelt, die unterschiedlich einstellbar sind, um eine Frequenzsteuerung zu gewährleisten, und in konstanter Weise den Kondensator leeren, in dem der Ausgangsstrom der FET-Stromquellen abnimmt, wenn die Temperatur zunimmt, wodurch Temperaturschwankungen der bipolaren Transistoren ausgeglichen werden;
ein Widerstandsmittel, das zwischen den Kollektoren der bipolaren Transistoren und einer zweiten Stromversorgungsleitung gekoppelt ist, um deren Strom zu regulieren, um ein Verhältnis lineare Frequenz zu Spannung bereitzustellen; und
eine Mehrzahl an Dioden, die mit dem Widerstandsmittel in Reihe geschaltet ist, um durch das Widerstandsmittel den Strom zu regulieren.

2. Ein spannungsgesteuerter Oszillator gemäß Anspruch 1, des weiteren bestehend aus einer Mehrzahl an FET-Ladungen zum Aufbau der Ausgangsspannung des Oszillators.

3. Ein spannungsgesteuerter Oszillator gemäß einem der Ansprüche 1 oder 2, des weiteren bestehend aus einem Begrenzungsmittel zur Begrenzung der Ausgangsspannungsschwingung des Multivibrators zur Erhöhung von dessen Schaltgeschwindigkeit.

4. Ein spannungsgesteuerter Oszillator gemäß Anspruch 3, in dem das Begrenzungsmittel ein FET mit niedrigem Schwellenwert ist.

5. Ein Verfahren zur Erzeugung von temperaturstabilen, spannungssteuerbaren Oszillatorsignalen, das folgende Schritte umfaßt:
Schaltung eines emittergekoppelten Multivibrators, der ein Paar bipolare Transistoren und einen Kondensator, der zwischen den Emittern der bipolaren Transistoren gekoppelt ist, umfaßt, wobei der Multivibrator als Ergebnis dadurch, daß das bipolare Gerät Temperaturabweichungen unterliegt, Frequenzschwankungen ausgesetzt ist;
Ausgleich von Temperaturschwankungen der bipolaren Transistoren mit einstellbaren FET-Stromquellen, die zwischen den Emittern der bipolaren Transistoren und einer dazugehörigen Stromversorgungsleitung gekoppelt ist, durch Senkung des Ausgangsstroms der FET-Stromquelle bei ansteigender Temperatur;
Regulierung des Stroms des bipolaren Geräts zur Bereitstellung eines Verhältnisses lineare Frequenz zu Spannung durch Kopplung eines Widerstandsmittels zwischen den Kollektoren der bipolaren Transistoren und einer zweiten Stromversorgungsleiste; und
Schaltung des Widerstandsmittels in Reihe mit einer Mehrzahl an Dioden, wodurch der Strom durch das Widerstandsmittel reguliert wird.

## Revendications

1. Oscillateur commandé en tension comprenant :
un multivibrateur à couplage d'émetteurs formé de deux transistors bipolaires couplés transversalement pour commuter le multivibrateur, le multivibrateur étant soumis à des variations de fréquence des suites de l'exposition des transistors bipolaires à des fluctuations de température;
des sources de courant couplés entre les émetteurs des transistors bipolaires et une ligne d'alimentation correspondante; et
un condensateur connecté entre les émetteurs des transistors bipolaires,
caractérisé en ce que les sources de courant sont des sources de courant à effet de champ qui sont réglables pour fournir la commande de fréquence et qui drainent constamment le condensateur, le courant de sortie des sources de courant à effet de champ décroissant au fur et à mesure que la température augmente pour compenser les fluctuations de température des transistors bipolaires;
un élément résistant couplé entre les collecteurs des transistors bipolaires et un second pôle de l'alimentation pour réguler leur courant et fournir un rapport linéaire fréquence/tension;
et une pluralité de diodes couplées en série avec l'élément résistant pour réguler le courant traversant l'élément résistant.

2. Oscillateur commandé en tension selon la revendication 1 comprenant, de plus, une pluralité de charges de TEC pour établir le courant de sortie de l'oscillateur.

3. Oscillateur commandé en tension selon l' une quelconque des revendications 1 et 2, comprenant de plus un dispositif limiteur pour limiter l'excursion de la tension de sortie du multivibrateur afin d'en améliorer la vitesse de commutation.

4. Oscillateur commandé en tension selon la revendication 3, dans lequel le dispositif limiteur est une TEC à bas seuil.

5. Procédé pour générer des signaux périodiques commandables en tension, stables en température, comprenant les étapes consistant à :
commuter un multivibrateur à couplage d'émetteurs comprenant une paire de transistors bipolaires et un condensateur couplé entre les émetteurs des transistors bipolaires, le multivibrateur étant soumis à des variations de fréquence des suites de l'exposition des transistors bipolaires à des fluctuations de température;
compenser les fluctuations de température des transistors bipolaires avec des sources de courant à effet de champ réglables couplées entre les émetteurs des transistors bipolaires et une ligne d'alimentation correspondante, en réduisant le courant de sortie des sources de courant à effet de champ au fur et à mesure que la température augmente;
réguler le courant des transistors bipolaires pour fournir un rapport linéaire fréquence/tension en couplant un élément résistant entre les collecteurs des transistors bipolaires et un second pôle de l'alimentation; et
connecter l'élément résistant en série avec une pluralité de diode pour réguler le courant traversant l'élément résistant.
